(19) Europäisches Patentamt
European Patent Office
Office européen des brevets

(11) **EP 0 914 699 B1**

(12) **FASCICULE DE BREVET EUROPEEN**

(45) Date de publication et mention
de la délivrance du brevet:
**26.12.2007 Bulletin 2007/52**

(51) Int Cl.:
*H01S 5/10* *(2006.01)*  *H01S 5/40* *(2006.01)*
*H01S 5/32* *(2006.01)*

(21) Numéro de dépôt: **98917218.4**

(22) Date de dépôt: **24.03.1998**

(86) Numéro de dépôt international:
**PCT/FR1998/000589**

(87) Numéro de publication internationale:
**WO 1998/044603 (08.10.1998 Gazette 1998/40)**

(54) **LASER COMPRENANT UN EMPILEMENT DE DIODES LASER EPITAXIEES COMPRIS ENTRE DEUX MIROIRS DE BRAGG**

Laservorrichtung mit einem zwischen zwei Bragg Spiegeln angebrachten Stapel epitaktischer Diodenlaser

LASER COMPRISING STACKED LASER DIODES PRODUCED BY EPITAXIAL GROWTH INSERTED BETWEEN TWO BRAGG MIRRORS

(84) Etats contractants désignés:
**DE GB**

(30) Priorité: **01.04.1997 FR 9703935**

(43) Date de publication de la demande:
**12.05.1999 Bulletin 1999/19**

(73) Titulaire: **Thales**
**75008 Paris (FR)**

(72) Inventeurs:
• **NAGLE, Julien,**
**Thomson-CSF SCPI**
**F-94117 Arceuil Cedex (FR)**
• **ROSENCHER, Emmanuel,**
**Thomson-CSF SCPI**
**F-94117 Arceuil Cedex (FR)**

(74) Mandataire: **Esselin, Sophie et al**
**Marks & Clerk France**
**31-33 Avenue Aristide Briand**
**94117 Arceuil Cedex (FR)**

(56) Documents cités:
**EP-A- 0 580 104**        **WO-A-95/07566**
**US-A- 5 212 706**

• **Y. KOTAKI S UCHIYAMA ET AL: "gaInAsP/InP surface emitting laser with two active layers" INTERNATIONAL CONFERENCE ON SOLID STATE DEVICES AND MATERIALS., 1984, TOKYO JA, pages 133-136, XP002050295**
• **R.D DUPUIS, P.D. DAPKUS: "Room temperature operation of distributed bragg confinement GaAlAs-GaAs lasers grown by metal organic chemical vapor deposition" APPLIED PHYSICS LETTERS., vol. 33, no. 1, 1 juillet 1978, NEW YORK US, pages 68-69, XP002050296**
• **YEH,YARIV: "Bragg reflection waveguides" OPTICS COMM, vol. 19, no. 3, pages 427-430, XP009017474**

EP 0 914 699 B1

## Description

Le domaine de l'invention est celui des lasers comprenant un empilement de lasers à semiconducteurs permettant d'atteindre des puissances de l'ordre de plusieurs kilowatts.

Selon l'art connu, de tels lasers comprennent des diodes laser réalisées par croissance épitaxiale, sur un substrat semiconducteur $C_n$ dopé par des impuretés d'un certain type (généralement de type n) d'une structure émettrice à puits quantique PQ puis d'une couche dopée par des impuretés de type opposé $C_p$ (généralement de type p).

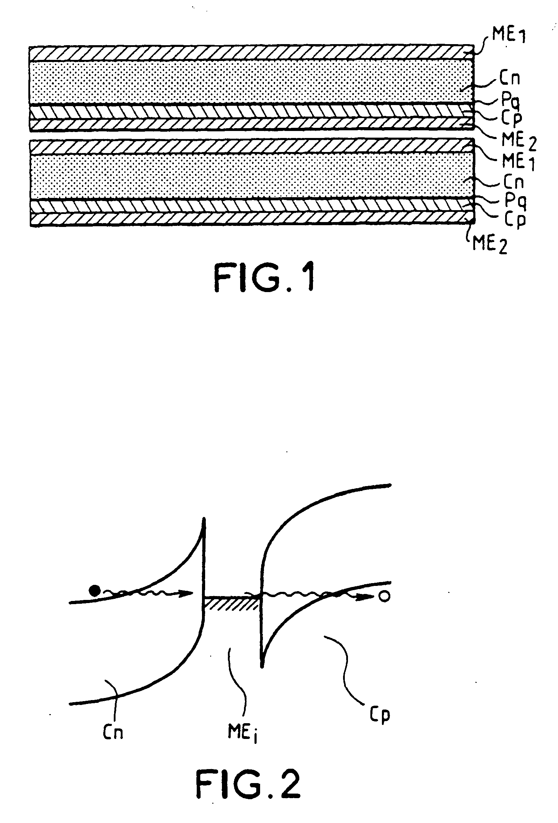

La figure 1 illustre un empilement selon l'art connu de deux diodes laser : des contacts métalliques $ME_1$ et $ME_2$ sont déposés de part et d'autre des diodes laser et les diodes laser sont empilées couche $C_n$ sur couche $C_p$, via les contacts métalliques $ME_1$ et $ME_2$.

Généralement des mâchoires métalliques mécaniques enserrent l'ensemble des diodes, pour assurer l'évacuation de la chaleur due aux effets thermiques importants qui ont lieu au niveau de chaque diode laser. Les diodes sont mises en contact électrique par soudure entre une métallisation $ME_1$ et une métallisation $ME_2$. Les électrons traversent par effet tunnel la jonction Schottky correspondant à l'interface d'une couche $C_n$ et d'une métallisation $ME_1$, alors que les trous peuvent traverser par effet tunnel la jonction Schottky correspondant à l'interface couche $C_p$ et métallisation $ME_2$. Ceci est illustré sur la figure 2 qui représente le diagramme des bandes d'énergie des couches $C_n$, $ME_i$ et $C_p$, utilisées dans un empilement de diodes laser selon l'art antérieur.

Les structures émettrices à puits quantiques sont espacées d'au moins l'épaisseur d'une couche substrat (typiquement une couche $C_n$ représentée sur la figure 1), soit plusieurs centaines de microns. Dans cette configuration les diodes doivent être pilotées par des impulsions suffisamment courtes pour que les longueurs de diffusion des gradients de température Ld ne se recouvrent pas, pour éviter localement des élévations de températures trop importantes, la longueur Ld étant donnée par l'équation (1) suivante :

$$Ld = \left(\frac{k\tau}{\rho K_\rho}\right)^{1/2}$$

avec

    k : conductibilité thermique
    $\tau$ : durée de l'impulsion
    $\rho$ : densité du semiconducteur
    Kp : capacité calorifique du semiconducteur.

Pour des substrats d'environ 400 $\mu$m d'épais-seur, on obtient typiquement des longueurs Ld de l'ordre de 200 $\mu$m pour des durées d'impulsions de l'ordre de 70 à 100 microsecondes.

Ces configurations de diodes laser empilées présentent l'inconvénient de nécessiter l'utilisation de moyens extérieurs pour réaliser l'assemblage (soudure notamment) et présentent une taille difficile à minimiser davantage, en raison de l'épaisseur du substrat de chaque diode élémentaire.

EP 05 801 104 A décrit un laser comprenant un empilement de diodes laser constitué de couches semiconductrices épitaxiées, le contact chimique entre deux diodes laser contiguës étant assuré par une fonction de type diode Esaki, et l'empilement des diodes étant inséré entre deux miroirs plans perpendiculaires ou plan des couches de manière à créer une émission laser parallèle au plan des couches.

Pour résoudre ces problèmes, l'invention propose une structure laser dans laquelle l'empilement des diodes laser est réalisé de façon périodique par croissance épitaxiale d'un ensemble de couches semiconductrices, ne nécessitant pas d'intervention manuelle.

L'invention a pour objet un laser tel que défini dans la revendication 1.

Plus précisément, les jonctions étant de type diode Esaki, ce laser selon l'invention peut comprendre un empilement de N diodes laser, caractérisé en ce que l'empilement de couches épitaxiées comprend des couches $S_j$, des couches $C'_{ni}$ dopées de type n, des couches $C'_{pi}$ dopées de type p, une couche $C'_{ni}$ étant adjacente à une couche $C'_{pi+1}$, le taux de dopage $t'_{ni}$ des couches $C'_{ni}$ et les taux de dopage $t'_{pi}$ des couches $C'_{pi}$ étant tels qu'un flux d'électrons est en mesure de passer par effet tunnel d'une couche $C'_{pi}$ vers une couche $C'_{ni+1}$ de manière à assurer le contact ohmique entre une diode $DL_i$ et une diode $DL_{i+1}$.

Comme les porteurs libres présents en très grande quantité à la jonction de type diode Esaki absorbent l'onde optique générée, l'invention propose une structure laser conçue pour que le champ électrique optique du mode s'annule au niveau de la position des jonctions de type diode Esaki.

Cette solution est intéressante dans la mesure où elle permet de conserver des structures laser de faibles dimensions, en comparaison avec une structure laser dans laquelle on choisit d'éloigner les jonctions entre diodes de la zone d'émission laser.

Selon l'art connu, par exemple document WO 9507566 l'empilement de diodes $(DI_i)$ est inséré entre deux miroirs plans parallèles au plan des couches semiconductrices épitaxiées, de manière à créer une émission laser perpendiculaire au plan des couches.

Avantageusement, les miroirs peuvent être des miroirs de Bragg, dont l'un présente une réflectivité voisine de 100 % pour l'onde optique créée, l'autre miroir de Bragg ayant une réflectivité plus faible de manière à permettre la sortie de l'émission laser.

Selon l'invention, l'empilement de diodes $(DI_i)$

est inséré entre deux miroirs plans perpendiculaires au plan des couches semiconductrices epitaxiées, de manière à créer une émission laser parallèle au plan des couches.

L'onde optique est confinée dans l'empilement des diodes en insérant l'ensemble des couches épitaxiées entre deux structures ou couches de confinement.

Ces structures de confinement peuvent notamment être constituées de miroirs de Bragg, présentant une réflectivité voisine de 100 % vis-à-vis de l'onde optique créée dans la cavité laser.

L'invention sera mieux comprise et d'autres avantages apparaîtront à la lecture de la description qui va suivre donnée à titre non limitatif et grâce aux figures annexées parmi lesquelles :

- la figure 1 illustre un empilement de diodes laser selon l'art antérieur ;
- la figure 2 représente le diagramme des bandes d'énergie des couches $C_n$, $ME_i$ et $C_p$ utilisées dans un empilement de diodes laser selon l'art antérieur ;
- la figure 3 illustre un exemple d'empilement de diodes laser selon l'invention, utilisant des jonctions de type Esaki ;
- la figure 4a illustre le diagramme de bande d'énergie de l'empilement de diodes laser utilisées dans un laser selon l'invention comprenant des jonctions de type Esaki en absence de tension ;
- la figure 4b illustre les diagrammes de bande d'énergie de l'empilement de diodes laser utilisées dans un laser selon l'invention comprenant des jonctions de type Esaki en présence d'une tension appliquée ;
- la figure 5 illustre un exemple de laser selon l'invention comprenant deux miroirs de Bragg de réflexion maximale, des diodes Esaki, et émettant selon un plan parallèle au plan des diodes ;
- la figure 6 illustre le champ optique créé par le laser selon l'invention, à proximité du laser (champ proche) et éloigné du laser (champ lointain) ;
- la figure 7 illustre un exemple de laser selon l'art connu à émission surfacique, utilisant un miroir de Bragg, partiellement transparent ;
- la figure 8 illustre l'évolution de la température d'un laser selon l'invention, au centre dudit laser, en fonction du temps, au cours d'une impulsion ;
- la figure 9 illustre la durée d'impulsion maximale permise en fonction de l'épaisseur d'une structure laser selon l'invention pour un écart de température admis To = 10 K.

Selon l'invention, la structure laser selon l'invention comprend un ensemble de couches semiconductrices épitaxiées de manière à réaliser un empilement de diodes lasers, deux diodes lasers contiguës étant mises en contact électrique par l'intermédiaire de jonctions de type diode Esaki, formée d'une région dopée très fortement de type p et d'une région dopée très fortement de type n. On sait en effet comme exposé par exemple dans le livre de S.M. Sze, Physics of Semiconductor Devices, John Wiley (New York, 1983) qu'une telle jonction polarisée en inverse (comme cela est le cas dans la structure empilée de l'invention) permet le passage des électrons de la bande de valence du côté fortement dopé p vers la bande de conduction du côté fortement dopé n.

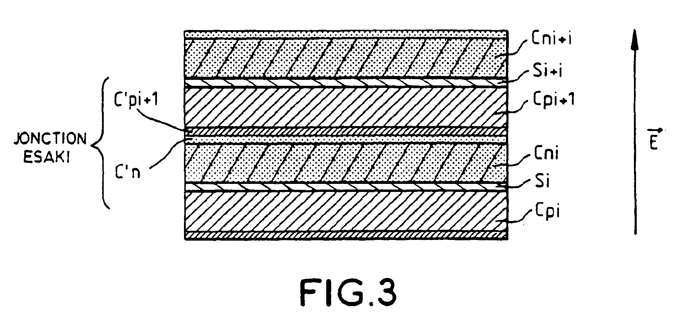

La structure émettrice $S_i$ de chaque diode laser peut être comprise entre deux couches de confinement optique d'indice plus faible, l'une des couches $C_{ni}$ étant dopée de type n, l'autre couche $C_{pi}$ étant dopée de type p. La figure 3 montre l'empilement d'une diode laser $D_{i+1}$ sur une diode laser $D_i$ par l'intermédiaire des couches fortement dopées $C'_{ni}$ et $C'_{pi+1}$. Le vecteur champ électrique E indique le sens de polarisation électrique à appliquer en fonctionnement pour permettre les recombinaisons électrons-trous au niveau des structures émettrices $S_i$.

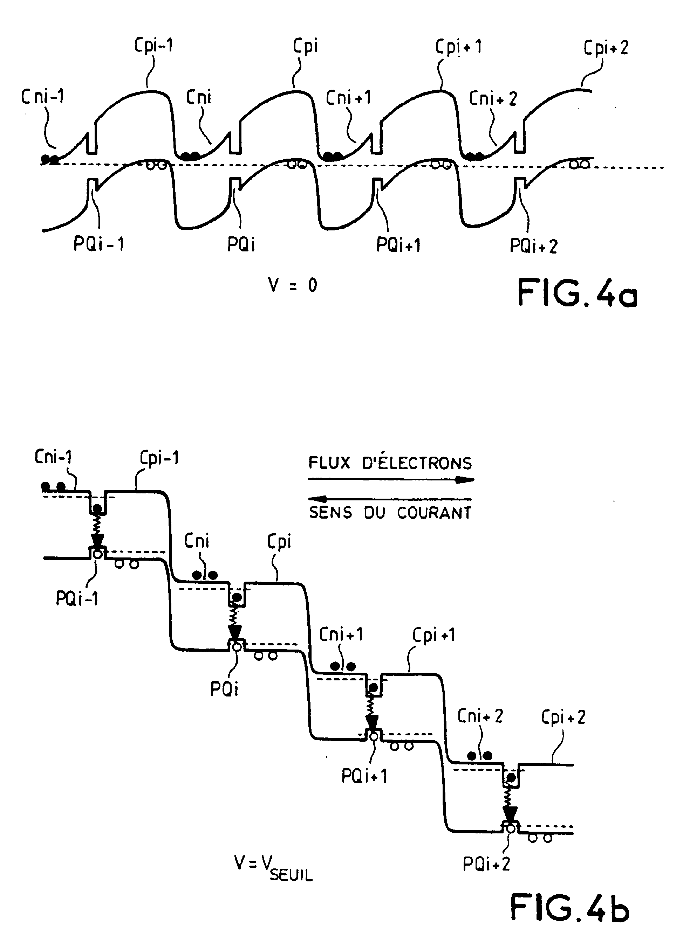

La figure 4a illustre le diagramme de bandes d'énergie de l'ensemble des couches semiconductrices permettant d'élaborer l'empilement de diodes laser selon l'invention, sans tension appliquée.

La figure 4b illustre le diagramme de bandes d'énergie de l'ensemble des couches semiconductrices permettant d'élaborer l'empilement de diodes laser selon l'invention, avec une tension appliquée.

Plusieurs structures à puits quantiques ont été représentées pour mettre en évidence le passage des électrons à chaque jonction. Ainsi 4 diodes laser sont ici illustrées par une succession de couches $Cn_j$, de structures à puits quantiques $PQ_j$ et de couches $Cp_j$.

La figure 4a montre les diagrammes de bande d'énergie d'une telle structure. A tension nulle, les jonctions en série présentent des barrières de potentiel périodiques. Sous une tension en polarisation directe appliquée à la structure totale, les jonctions de type Esaki sont toutes polarisées en inverse. Comme l'indique la figure 4b, pour une tension suffisamment importante, le système se configure en bandes plates. Une fois en bandes plates (avec des chutes de potentiel faibles aux jonctions), la structure laisse passer le courant et les couches se mettent à laser. Le principe de fonctionnement peut s'interpréter de la façon suivante : l'électron ayant effectué une transition optique à la jonction $S_i$ est injecté de la région $C_{pi}$ à la région $C_{ni+1}$ par la jonction Esaki $C_{pi}/C_{ni+1}$. On notera que la diode Esaki peut être réalisée dans un semiconducteur ayant un gap plus petit que le substrat pour diminuer la résistance de contact de la diode, en utilisant un alliage InGaAs sur du GaAs par exemple.

Selon une première variante, l'empilement de diodes est inséré entre deux miroirs plans perpendiculaires au plan des couches. Un premier miroir présentant une réflectivité voisine de 100 %, l'autre miroir présentant une réflectivité inférieure.

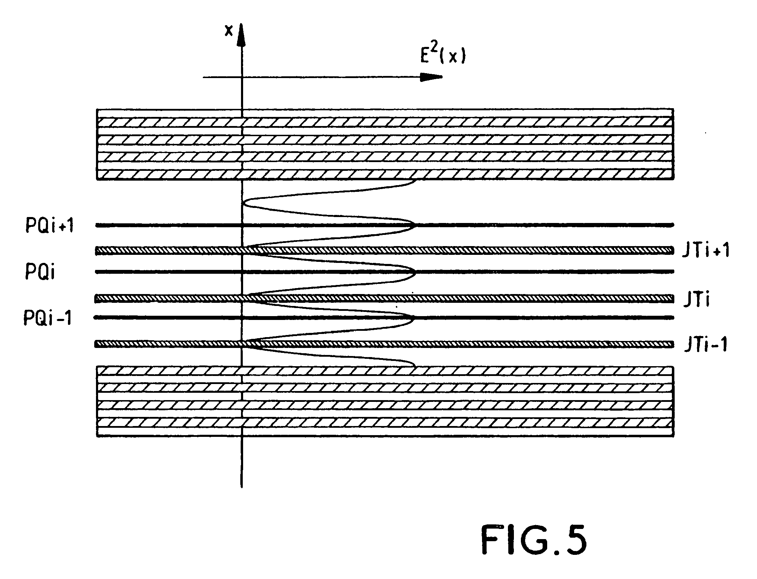

Pour assurer l'annulation du champ électrique optique du mode créé au niveau des jonctions de type Esaki, l'empilement de diodes peut avantageusement être intégré entre deux séries de miroirs de Bragg parallèles au plan des couches, présentant une réflectivité voisine de 100 %. La structure constitue un guide, tel que le mode guidé ait un champ électrique nul, au niveau des jonctions Esaki $JT_I$, le faisceau laser étant émis parallèlement aux couches (voir figure 5), E(x) représentant le champ électrique de l'onde optique dans la cavité laser. A titre d'exemple, pour 10 étages, l'épaisseur totale serait alors de 10 fois la demi longueur d'onde divisée par l'indice optique soit de l'ordre de 2 $\mu$m.

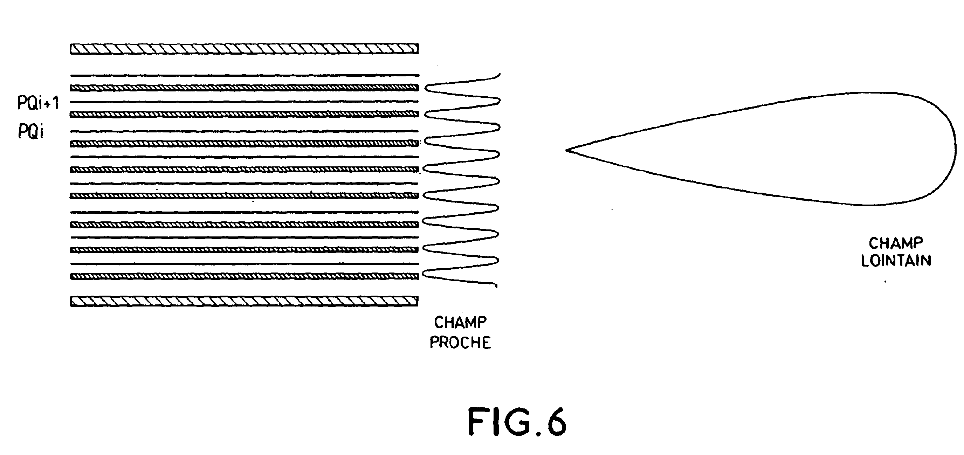

Dans cette configuration, les couches lasers sont très fortement couplées entre elles et leurs émissions peuvent être naturellement mises en phase. On obtient ainsi un réseau vertical de lasers en phase ce qui est extrêmement difficile à obtenir en géométrie horizontale. On sait que ces réseaux peuvent émettre des faisceaux dont la divergence est beaucoup plus faible que dans un laser seul (A. Yariv, Quantum Electronics, Wiley Interscience). La figure 6 illustre à ce titre, l'étendue du champ optique dit proche du laser et l'étendue du champ optique dit lointain.

Nous donnons maintenant un exemple de réalisation. Le substrat est du GaAs fortement dopé de type n+ (typiquement $10^{18}$ cm$^{-3}$). Une couche tampon GaAs n+ est réalisée suivant les règles de l'art puis le composant est constitué d'un empilement de structures élémentaires suivantes : une barrière AlGaAs très dopée de type p suivie d'une couche de GaAs dopée n++ (quelques $10^{19}$ cm$^{-3}$) puis dopée p++. Chaque couche élémentaire a une épaisseur typique de 1 $\mu$m. La résistance de contact n++/p++ est typiquement de $10^{-4}$ ohm.cm$^{-2}$. Comme les courants de lasers sont de l'ordre de 15 kA/cm$^2$, on assiste à une chute de potentiel de 100 millivolts à chaque jonction Esaki. Cette chute de potentiel peut être diminuée en utilisant une diode Esaki en $In_{0.2}Ga_{0.8}gAs$ qui conduit grâce à la diminution du gap vis-à-vis de celui de GaAs, à une chute de tension de 30 mV.

Selon l'art connu, l'émission laser est obtenue perpendiculairement au plan des diodes, pour cela l'empilement des diodes peut être intégré entre deux miroirs de Bragg dont l'un est légèrement transparent, le plan desdits miroirs étant parallèle au plan des diodes.

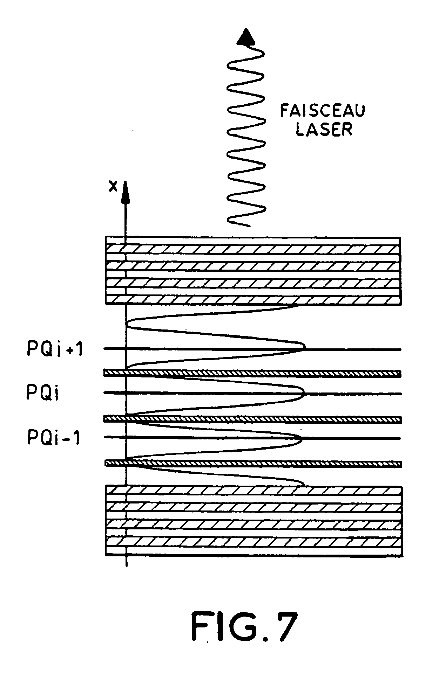

La structure est réalisée sous forme de mésa de petites dimensions. L'émission laser a alors lieu par la surface et le système est donc de type VCSEL (Vertical Cavity Surface Emission Laser) (voir figure 7). Notons que dans ce cas, les deux miroirs de Bragg peuvent être dopés n, ce qui diminue considérablement les résistances d'accès et facilite grandement le procédé de réalisation du VCSEL.

Les empilements de diodes lasers épitaxiées selon l'invention, ont un comportement thermique différent des diodes lasers empilées selon l'art antérieur :

Malgré la proximité accrue des structures émettrices entre elles, et des zones d'échauffement maximal, les structures selon l'invention sont en mesure d'évacuer la chaleur de manière satisfaisante.

Dans les structures classiques utilisant plusieurs diodes fabriquées au préalable, puis empilées, la température décroît linéairement dans chaque couche sur une distance donnée par l'équation (1) définie précédemment (typiquement sur une distance de 200 $\mu$m pour une durée de 100 $\mu$s).

Dans la structure épitaxiée selon l'invention, la température peut être considérée comme homogène sur toute l'épaisseur de chaque diode laser au bout d'un temps très court, en raison des faibles distances qui séparent deux régions émettrices $S_i$. Les embases métalliques constituent des réservoirs thermiques.

On considère ainsi que la structure active est placée entre deux réservoirs thermiques à une température relative T = 0 et que durant une impulsion de courant, la puissance thermique dissipée est distribuée de manière homogène dans toute la structure active.

Si x correspond à la distance à partir du centre de la structure en direction d'un réservoir thermique, le champ de température T (x, t) en fonction de cette distance et du temps, est alors déterminé par l'équation de diffusion (2) :

$$\partial T / \partial t = D\, \partial^2 T / \partial x^2 + P / \rho c_p L$$

avec

> D : constante de diffusion thermique
> P : puissance thermique divisée par la section du laser
> L : l'épaisseur de l'ensemble du laser correspondant à la structure épitaxiée.

Les conditions limites de cette équation (2) sont :

> T(-L/2, t) = T(L/2, t) = 0

> et T(x, 0) = 0

En redimensionnant avec comme unité de longueur L, unité de temps $L^2/D$ et unité de température PL/$\rho C_p D$ ou bien encore PL/K, K étant la conductibilité thermique, on obtient aussi l'équation suivante (3) :

$$\partial T / \partial t' = \partial^2 T / \partial x'^2 + 1$$

La solution stationnaire de l'équation 3 étant l'équation suivante (4) :

$$T_\infty(x') = 1/8 - x'^2/2$$

et la température maximale en continu est donc $T_{max}$ = PL/8K

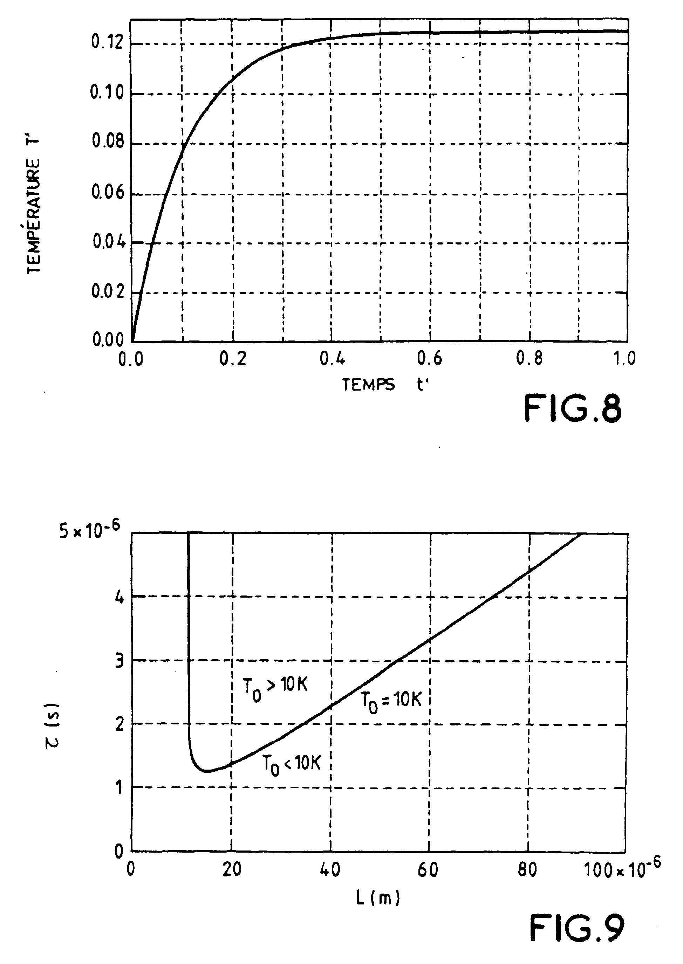

A ce titre la figure 8 illustre les résultats de l'évolution de la courbe T' (0, t) au centre de la structure. Deux domaines sont facilement mis en évidence : pour t' petit, la température monte linéairement, indiquant que la chaleur n'est pas du tout évacuée vers les réservoirs, et pour t' plus grand, la température se stabilise à la valeur stationnaire indiquant que la chaleur est évacuée en permanence.

Ces principes peuvent être appliqués dans le cas précis d'une structure laser selon l'invention à base de GaAs. Compte tenu d'une élévation de température $T_0$ admissible et d'une épaisseur de laser donnée L, on est en mesure à partir d'une courbe de type représentée en figure 6, de déterminer les durées d'impulsion maximales que peut supporter la structure laser en fonction des paramètres imposés tels que l'élévation de température admissible.

Un exemple est illustré en figure 9, les constantes du matériau **GaAs étant les suivantes :**

D = $2,5.10^{-5}$m$^2$/s
K=46 W m$^{-1}$.K$^{-1}$
P = 2 kW/0,06.10$^{-6}$m$^2$
$T_0$= 10 K

La courbe de la figure 9 fournit la durée d'impulsion maximale $\tau$ en secondes en fonction de l'épaisseur L du laser exprimée en mètres. La courbe illustrée sur cette figure est relative à une température $T_0$ = 10 K.

**Revendications**

1. Laser comprenant un empilement de N diodes laser ($DL_i$) comportant chacune une structure émettrice à puits quantique ($S_i$) don t:

    - l'empilement de diodes ($DL_i$) est un empilement de couches semiconductrices épitaxiées réalisé de façon périodique, inséré entre deux miroirs plans perpendiculaires au plan des couches semiconductrices épitaxiées, de manière à réaliser une cavité laser et créer une émission laser parallèle au plan des couches;
    - le contact ohmique entre une première diode laser ($DL_i$) et une seconde diode laser ($DL_{i+1}$) contiguës est assuré par une jonction de type Esaki, **caractérisé en ce que**
    - l'empilement de diodes (DLi) est inséré entre deux ultérieurs miroirs constitués par deux miroirs de Bragg ($M'_1$) et ($M'_2$) parallèles au plan des couches semiconductrices et présentant une réflectivité voisine de 100% de manière à créer un guide d'onde tel que le champ électrique du mode guidé s'annule périodiquement au niveau des jonctions de type Esaki.

2. Laser comprenant un empilement de N diodes laser selon la revendication 1, **caractérisé en ce que** l'empilement de couches épitaxiées comprend des couches émettrices ($S_i$), des couches ($C'_{ni}$) fortement dopées de type n, des couches ($C'_{pi}$) fortement dopées de type p, une première couche fortement dopée de type n ($C'_{ni}$) étant adjacente à une seconde couche fortement dopée de type p ($C'_{pi+1}$), les premiers taux de dopage ($t'_{ni}$) des couches fortement dopées de type n ($C'_{ni}$) et les premiers taux de dopage ($t'_{pi}$) des couches fortement dopées de type p ($C'_{pi}$) étant tels qu'un flux d'électrons est en mesure de passer par effet tunnel d'une première couche fortement dopée de type p ($C'_{pi}$) vers une seconde couche fortement dopée de type n ($C'_{ni+1}$) de manière à assurer le contact ohmique entre une première diode ($DL_i$) et une seconde diode ($DL_{i+1}$).

3. Laser comprenant un empilement de N diodes laser selon la revendication 2, **caractérisé en ce que** les diodes ($DL_i$) comprennent une couche ($C_{ni}$) dopée de type n de taux de dopage ($t_{ni}$) inférieur au taux de dopage d'une couche fortement dopée de type n ($t'_{ni}$), une structure émettrice ($S_i$) et une couche ($C_{pi}$) dopée de type p de taux de dopage ($t_{pi}$) inférieur au taux de dopage d'une couche fortement dopée de type p ($t'_{pi}$).

4. Laser comprenant un empilement de N diodes laser selon la revendication 3, **caractérisé en ce que** les couches fortement dopées de type p ($C'_{pi}$) et les couches fortement dopées de type n ($C'_{ni}$) sont réalisées à partir de $In_{1-x}Ga_xAs$, les couches dopées de type p ($C_{pi}$) et les couches dopées de type n ($C_{ni}$) étant réalisées à partir de AlGaAs, les structures ($S_i$) à partir de GaAs.

**Claims**

1. Laser comprising a stack of N laser diodes ($DL_i$), each having a quantum-well emissive structure ($S_i$), in which:

    - the stack of diodes ($DL_i$) is a stack of epitaxial semiconductor layers stacked periodically which is inserted between two plane mirrors which are perpendicular to the plane of the epitaxial semiconductor layers, so as to produce a laser cavity and generate laser emission parallel to the plane of the layers;
    - the ohmic contact between a first laser diode ($DL_i$) and a second laser diode ($DL_{i+1}$) which are adjoining is provided by an Esaki junction, **characterized in that**
    - the stack of diodes ($DL_i$) is inserted between two subsequent mirrors consisting of two Bragg mirrors ($M'_1$) and ($M'_2$) parallel to the plane of the semiconductor layers and having a reflectivity close to 100%, so as to create a waveguide,

such that the electric field of the guided mode is periodically cancelled at the Esaki junctions.

2. Laser comprising a stack of N laser diodes according to Claim 1, **characterized in that** the stack of epitaxial layers comprises emissive layers ($S_i$), heavily n-doped layers ($C'_{ni}$), heavily p-doped layers ($C'_{pi}$), a first heavily n-doped layer ($C'_{ni}$) being adjacent to a second heavily p-doped layer ($C'_{pi+1}$), the first doping levels ($t'_{ni}$) of the heavily n-doped layers ($C'_{ni}$) and the first doping levels ($t'_{pi}$) of the heavily p-doped layers ($C'_{pi}$) being such that an electron flow is capable of passing by the tunnel effect from a first heavily p-doped layer ($C'_{pi}$) to a second heavily n-doped layer ($C'_{ni+1}$) so as to provide the ohmic contact between a first diode ($DL_i$) and a second diode ($DL_{i+1}$).

3. Laser comprising a stack of N laser diodes according to Claim 2, **characterized in that** the diodes ($DL_i$) comprise an n-doped layer ($C_{ni}$) with a doping level ($t_{ni}$) less than the doping level of a heavily n-doped layer ($t'_{ni}$), an emissive structure ($S_i$) and a p-doped layer ($C_{pi}$) with a doping level ($t_{pi}$) less than the doping level of a heavily p-doped layer ($t'_{pi}$).

4. Laser comprising a stack of N laser diodes according to Claim 3, **characterized in that** the heavily p-doped layers ($C'p_i$) and the heavily n-doped layers ($C'_{ni}$) are made of $In_{1-x}Ga_xAs$, the p-doped layers ($Cp_i$) and n-doped layers ($C_{ni}$) being made from AlGaAs, and the structures ($S_i$) from GaAs.

**Patentansprüche**

1. Laser mit einem Stapel von N Laserdioden ($DL_i$), die je eine emittierende Struktur mit Quantentrog ($S_i$) aufweisen, wobei

   - der Stapel von Dioden ($DL_i$) ein Stapel von epitaxierten Halbleiterschichten ist, der periodisch hergestellt wird, eingefügt zwischen zwei ebene Spiegel lotrecht zur Ebene der epitaxierten Halbleiterschichten, um einen Laserhohlraum herzustellen und eine Laseremission parallel zur Ebene der Schichten zu erzeugen,
   - der ohmsche Kontakt zwischen einer ersten Laserdiode ($DL_i$) und einer zweiten Laserdiode ($DL_{i+1}$), die aneinander grenzen, von einer Verbindung vom Typ Esaki gewährleistet wird,

   **dadurch gekennzeichnet, dass**

   - der Stapel von Dioden ($DL_i$) zwischen zwei weitere Spiegel eingefügt wird, die aus zwei Bragg-Spiegeln ($M'_1$) und ($M'_2$) bestehen, die parallel zur Ebene der Halbleiterschichten liegen und ein Reflexionsvermögen nahe 100 % haben, um einen derartigen Wellenleiter zu erzeugen, dass das elektrische Feld des geführten Modus sich periodisch in Höhe der Verbindungen vom Typ Esaki annulliert.

2. Laser mit einem Stapel von N Laserdioden nach Anspruch 1, **dadurch gekennzeichnet, dass** der Stapel von epitaxierten Schichten emittierende Schichten ($S_i$), stark dotierte Schichten ($C'_{ni}$) vom n-Typ, stark dotierte Schichten ($C'_{pi}$) vom p-Typ aufweist, wobei eine erste stark dotierte Schicht ($C'_{ni}$) vom n-Typ einer zweiten stark dotierten Schicht ($C'_{pi+1}$) vom p-Typ benachbart ist, wobei die ersten Dotierungsgrade ($t'_{ni}$) der stark dotierten Schichten ($C'_{ni}$) vom n-Typ und die ersten Dotierungsgrade ($t'_{pi}$) der stark dotierten Schichten ($C'_{pi}$) vom p-Typ so sind, dass ein Elektronenfluss in der Lage ist, durch Tunneleffekt von einer ersten stark dotierten Schicht ($C'_{pi}$) vom p-Typ zu einer zweiten stark dotierten Schicht ($C'_{ni+1}$) vom n-Typ überzugehen, um den ohmschen Kontakt zwischen einer ersten Diode ($DL_i$) und einer zweiten Diode ($DL_{i+1}$) zu gewährleisten.

3. Laser mit einem Stapel von N Laserdioden nach Anspruch 2, **dadurch gekennzeichnet, dass** die Dioden ($DL_i$) eine dotierte Schicht ($C_{ni}$) vom n-Typ mit einem Dotierungsgrad ($t_{ni}$) geringer als der Dotierungsgrad ($t'_{ni}$) einer stark dotierten Schicht vom n-Typ, eine emittierende Struktur ($S_i$) und eine dotierte Schicht ($C_{pi}$) vom p-Typ mit einem Dotierungsgrad ($t_{pi}$) geringer als der Dotierungsgrad ($t'_{pi}$) einer stark dotierten Schicht vom p-Typ aufweist.

4. Laser mit einem Stapel von N Laserdioden nach Anspruch 3, **dadurch gekennzeichnet, dass** die stark dotierten Schichten ($C'_{pi}$) vom p-Typ und die stark dotierten Schichten ($C'_{ni}$) vom n-Typ ausgehend von $In_{1-x}Ga_xAs$ hergestellt werden, während die dotierten Schichten ($C_{pi}$) vom p-Typ und die dotierten Schichten ($C_{ni}$) vom n-Typ ausgehend von AlGaAs, die Strukturen ($S_i$) ausgehend von GaAs hergestellt werden.

FIG.1

FIG.2

FIG.3

Cni-1   Cpi-1     Cpi        Cpi+1       Cpi+2
        Cni       Cni+1      Cni+2

PQi-1      PQi       PQi+1       PQi+2

V = 0

**FIG.4a**

Cni-1    Cpi-1

FLUX D'ÉLECTRONS

SENS DU COURANT

PQi-1

Cni     Cpi

PQi

Cni+1    Cpi+1

Cni+2    Cpi+2

PQi+1

PQi+2

V = V$_{SEUIL}$

**FIG.4b**

$x$

$E^2(x)$

PQi+1

PQi

PQi-1

JTi+1

JTi

JTi-1

**FIG.5**

PQi+1

PQi

CHAMP
PROCHE

CHAMP
LOINTAIN

EP 0 914 699 B1

FIG.6

FAISCEAU
LASER

x

PQi+1

PQi

PQi-1

FIG.7

FIG.8

FIG.9

**EP 0 914 699 B1**

**RÉFÉRENCES CITÉES DANS LA DESCRIPTION**

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- EP 05801104 A
- WO 9507566 A